(19) Europäisches Patentamt
European Patent Office
Office européen des brevets

(11) **EP 2 548 004 B1**

(12) **EUROPÄISCHE PATENTSCHRIFT**

(45) Veröffentlichungstag und Bekanntmachung des Hinweises auf die Patenterteilung:
**07.05.2014 Patentblatt 2014/19**

(51) Int Cl.:
*G01N 21/35* (2014.01)     *G01N 21/39* (2006.01)
*H01S 5/022* (2006.01)

(21) Anmeldenummer: **11710169.1**

(22) Anmeldetag: **17.03.2011**

(86) Internationale Anmeldenummer:
**PCT/EP2011/054036**

(87) Internationale Veröffentlichungsnummer:
**WO 2011/113893 (22.09.2011 Gazette 2011/38)**

(54) **LEUCHTEINHEIT**

ILLUMINATION UNIT

UNITÉ D'ILLUMINATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.03.2010 DE 102010003034**

(43) Veröffentlichungstag der Anmeldung:
**23.01.2013 Patentblatt 2013/04**

(73) Patentinhaber: **Vertilas GmbH
85748 Garching (DE)**

(72) Erfinder: **SHAU, Robert
81545 München (DE)**

(74) Vertreter: **Kudlek & Grunert Patentanwälte
Postfach 33 04 29
80064 München (DE)**

(56) Entgegenhaltungen:
**EP-A1- 1 783 481     US-A- 5 637 872**

**Beschreibung**

Die vorliegende Erfindung betrifft eine Leuchteinheit für die Gasdetektion aufweisend eine Lichtquelle für linear polarisierte Lichtstrahlung und ein Gehäuse mit einem Austrittsfenster.

Stand der Technik

Die vorgestellte Erfindung verbessert die Eigenschaften von optischen Apparaten, die polarisiertes Licht mit variabler Wellenlänge benutzen. Typische Anwendungen sind Apparate mit abstimmbaren Laserdioden zur Gassensorik unter Nutzung der optischen Absorption der Gase. Optische Gassensoren basieren im Wesentlichen auf dem Prinzip der Infrarot(IR)-Spektroskopie. Das zu untersuchende Volumen wird mit monochromatischem Licht durchstrahlt, dessen Absorption in dem Volumen bestimmt wird. Durch Variation der Wellenlänge kann ein Spektrum aufgezeichnet werden, auf Grundlage dessen die vorhandenen Gase bestimmt werden können. Die Gassensorik erfordert daher besondere Leuchteinheiten, welche bspw. eine besonders hohe Wellenlängen- und Modenstabilität aufweisen.

Ein Gassensor sowie eine zugehörige Leuchteinheit sind aus der EP 1 783 481 A1 bekannt. Zur Verbesserung der Intensitätsstabilität wird vorgeschlagen, das Austrittsfenster relativ zur optischen Achse bzw. Hauptabstrahlrichtung um den Brewster-Winkel (hier ca. 57°) zu verkippen. Eine solche Verkippung kann bei linear polarisiertem Laserlicht in reiner p-Polarisation unerwünschte Rückreflexionen an der Kappe reduzieren.

Problematisch ist jedoch weiterhin, dass an dem Austrittsfenster Interferenzeffekte auftreten, die das zu messende Signal beeinträchtigen. Es treten störende optische Modulationen auf, die sich beispielsweise als Schwankungen der gemessenen Lichtintensität als Funktion der Wellenlänge in den Photodetektoren von Messapparaturen zur optischen Gasanalyse manifestieren. Insbesondere bei einer unter der Bezeichnung "Open Path Gas Detection" (OPGD) bekannten Anwendung, bei der der Laserstrahl über eine mehr oder weniger lange Strecke durch den zu überwachenden Raum geführt wird, sind Schwankungen der Strahlintensität besonders störend, da sie das Signal/Rausch-Verhältnis deutlich verschlechtern. Bei der Messung kann nämlich meistens nicht direkt zwischen einer Schwächung durch Absorption in einem Gas und einer Schwächung durch Interferenzeffekte unterschieden werden, was den zu betreibenden Messaufwand und die damit verbundenen Kosten signifikant erhöht.

Die US 5 637 872 A zeigt einen Gasdetektor um Gas in einem Target Bereich zu erkennen. Dabei wird ein keilförmiges Austrittsfenster genutzt, wodurch die Interferenzeffekte in einen Frequenzbereich verschoben werden, der sich von dem zu detektierenden Signal so deutlich unterscheidet, dass die Interferenzeffekte aus dem detektierten Signal herausgefiltert werden können.

Es ist daher besonders wünschenswert, eine abstimmbare Leuchteinheit mit variierbarer Wellenlänge für die Gassensorik anzugeben, bei der die Wellenlängenabhängigkeit der Lichtstrahlungsintensität nach dem Austrittsfenster reduziert ist.

Offenbarung der Erfindung

Erfindungsgemäß wird eine Leuchteinheit mit den Merkmalen des Patentanspruchs 1 vorgeschlagen. Vorteilhafte Ausgestaltungen sind Gegenstand der Unteransprüche sowie der nachfolgenden Beschreibung.

Vorteile der Erfindung

Die Erfindung basiert auf der Maßnahme, die Lichtquelle der Leuchteinheit so in dem Gehäuse mit Austrittsfenster anzuordnen, dass die Interferenzeffekte im durchstrahlten Bereich des Austrittsfensters möglichst gering werden. Dazu wird eine entsprechend optimale Ausrichtung der Haupterstreckungsebene des Austrittsfensters einerseits zur Polarisationsrichtung und andererseits zur Hauptabstrahlrichtung der Lichtstrahlung gewählt. Die Erfindung stellt damit eine wellenlängeneinstellbare Leuchteinheit für die Gasdetektion bereit, bei der die Wellenlängenabhängigkeit der Intensität des aus dem Austrittsfenster ausgetretenen Lichts deutlich reduziert ist. Bei einer erfindungsgemäßen Ausrichtung schließt die Hauptabstrahlrichtung der Lichtquelle mit einer Normalen auf der Haupterstreckungsebene des Austrittsfensters einen Neigungswinkel φ von vorzugsweise 30° ± 20° ein. Weiterhin schließt die Polarisationsrichtung mit der Einfallsebene (die, wie bekannt, durch die Normale auf der Haupterstreckungsebene des Austrittsfensters und die Hauptabstrahlrichtung der Lichtquelle aufgespannt wird) einen Rotationswinkel θ von vorzugsweise 45° ± 22,5° ein.

Eine besonders bevorzugte Ausführungsform betrifft einen Rotationswinkel θ von 45°, d.h. es liegt eine s+p-Polarisation vor. Dies ergibt einerseits eine besonders effektive Unterdrückung der Interferenzeffekte und andererseits eine für die Herstellung besonders günstige Invarianz des Systems gegenüber einer 90°-Rotation der Polarisationsebene der Lichtstrahlung. Somit wird die Herstellung vereinfacht, da es vier gleichwertige Anordnungsmöglichkeiten des Gehäuses bzw. des Austrittfensters zur Lichtquelle gibt. Die Erfindung umfasst jedoch auch Rotationswinkel, die innerhalb bevorzugter Bereiche von 10°, 15° oder 22,5° um 45° liegen.

Bevorzugterweise liegt der Neigungswinkel φ zwischen 20° und 40°, vorzugsweise zwischen 25° und 35°, insbesondere bei 30°. Es hat sich gezeigt, dass hierdurch ein besonders großer Spektralbereich mit geringer Längenwellenabhängigkeit erhalten werden kann. Weiterhin ist ein solcher, relativ geringer Neigungswinkel, deutlich einfacher herzustellen als die im Stand der Technik beschriebenen Neigungswinkel von bis zu 60°.

Durch die erfindungsgemäße Ausrichtung von Gehäuse und Lichtquelle wird auch der Einfluss der Dicke des Austrittsfensters reduziert. Bei den im Stand der Technik bekannten Ausrichtungen steigt der Einfluss der Störungen mit der Fensterdicke. Aus diesem Grund werden besonders dünne Fenster empfohlen, welche jedoch teuer herzustellen, empfindlich und wenig robust sind. Ein für die Erfindung günstiger Bereich für die Dicke des Austrittsfensters liegt zwischen 0,2 mm und 1,5 mm. Besonders bevorzugt beträgt die Dicke wenigstens 1 mm.

Aufgrund der deutlich reduzierten Wellenlängenabhängigkeit sind erfindungsgemäße Leuchteinheiten besonders gut für optische Gassensoren geeignet. Bei einer erfindungsgemäßen Verwendung einer Leuchteinheit wird ein Absorptionsspektrum aufgenommen, um das Vorhandensein von Gasen zu detektieren.

Zwar offenbart die US 7,113,658 B2 eine auf den ersten Blick ähnliche Leuchteinheit. Diese wird jedoch für die Datenübertragung eingesetzt und ist für die Gasdetektion aufgrund mangelnder Wellenlängen- und Modenstabilität ungeeignet. Auch kann diese Schrift den Fachmann nicht zum Gegenstand der Erfindung führen, da der dort gezeigten geometrischen Ausgestaltung vollkommen andere Überlegungen und Effekte zugrunde liegen. Die geometrische Ausgestaltung dient nämlich gerade nicht zur-Minimierung einer Wellenlängenabhängigkeit. Vielmehr dient die Verkippung des Austrittsfensters zur Abstrahlrichtung dazu, einen Teil des Lichts in eine Monitordiode auszukoppeln. Die Verdrehung des Austrittsfensters dient dazu, dass beide instabile Moden gleich gedämpft werden, so dass aus einem Modenspruch kein Intensitätssprung resultiert. Beide Ursachen, d.h. Monitordiode und Modeninstabilität, haben mit der der Erfindung zugrunde liegenden Problemstellung nichts zu tun.

Weitere Vorteile und Ausgestaltungen der Erfindung ergeben sich aus der Beschreibung und der beiliegenden Zeichnung.

Die Erfindung ist anhand eines Ausführungsbeispieles in der Zeichnung schematisch dargestellt und wird im Folgenden unter Bezugnahme auf die Zeichnung ausführlich beschrieben.

Figurenbeschreibung

Figur 1    zeigt schematisch eine Lichtquelle, ein Austrittsfenster sowie das sich ergebende Interferenzmuster bei senkrechtem Einfall von linear polarisiertem Licht.

Figur 2    zeigt schematisch eine Lichtquelle, ein Austrittsfenster sowie das sich ergebende Interferenzmuster bei schrägem Einfall von linear polarisiertem Licht unter einem Winkel von etwa 30°.

Figur 3    zeigt schematisch eine Lichtquelle und ein Austrittsfenster einer bevorzugten Ausführungsform einer erfindungsgemäßen Leuchteinheit sowie das sich durch den schrägen Einfall unter einem Winkel von etwa 30° und der s+p-Polarisation ergebende Interferenzmuster.

Figur 4    zeigt eine perspektivische Ansicht eines für die Erfindung geeigneten Gehäuses.

Figur 5    zeigt eine Ausführungsform eines erfindungsgemäßen Gassensors.

Zunächst werden die der Figurenbeschreibung zugrunde liegenden Erkenntnisse beschrieben:

Ein aus einer Apertur, wie z.B. von einer monomodigen Laserdiode oder von einer monomodigen Glasfaser, austretender Lichtstrahl stellt in guter Näherung im Fernfeld eine Kugelwelle mit einer gaußförmigen Intensitätsverteilung um die optische Achse dar, wobei die Intensitätsverteilung im Allgemeinen bei kantenemittierenden Laserdioden elliptisch und bei oberflächenemittieren Laserdioden oder Glasfasern kreisförmig sein wird. Dabei enthält der Strahl einen in mehreren Winkelrichtungen ausgedehnten Bereich von Ausbreitungsrichtungen, wobei die mittlere Ausbreitungsrichtung bzw. Hauptabstrahlrichtung des Strahls der optischen Achse entspricht.

Nachfolgend wird die Transmission eines solchen Strahls durch eine transparente plane Glasscheibe, z.B. ein Austrittsfenster, als strahlformendes Element wiederum im Fernfeld betrachtet. Die Überlegungen lassen sich auch auf Elemente mit anderen strahlformenden Eigenschaften, wie z.B. transparente Linsen oder Keile, sowie auf endliche räumliche Distanzen übertragen.

Es ist bekannt, dass beim Durchgang einer Kugelwelle durch eine plane Glasscheibe konzentrische Interferenzringe, in der Fachliteratur z.B. als "transmission fringes" bezeichnet, auftreten. Die Interferenzringe entstehen durch die Aufteilung des einfallenden Strahls aufgrund innerer Reflexionen an Grenzflächen zwischen Volumenbereichen mit unterschiedlichem Brechungsindex und Überlagerung der Teilstrahlen, die in bestimmten Ausbreitungsrichtungen je nach Brechungsindex und Dicke der Scheibe sowie Wellenlänge und Polarisation des Lichtstrahls mehr konstruktiv (helle Regionen) und in anderen Ausbreitungsrichtungen mehr destruktiv (dunkle Regionen) erfolgt. Das Winkelmuster der Interferenzringe ist unabhängig vom Abstand zwischen Apertur und Scheibe und unabhängig von Oberflächenbeschichtungen der Scheibe, wie sie üblicherweise zur Beeinflussung der Oberflächenreflektivität, insbesondere zur Herabsetzung derselben (Entspiegelung), aufgebracht werden, wobei der absolute Kontrast des Transmissionsgrads zwischen konstruktiven und destruktiven Ausbreitungsrichtungen bei einer Verminderung der Reflektivität in der Regel ebenfalls reduziert wird.

Steht im Falle von unpolarisiertem Licht die optische Achse senkrecht auf der Haupterstreckungsebene des Fensters, erscheinen die Interferenzringe als konzentrische Kreisringe, wobei im Zentrum um die optische Achse je nach Dicke und Brechungsindex der Scheibe sowie insbesondere je nach Wellenlänge des Lichts eine helle oder dunkle kreisförmige Winkelregion erscheint. Aus der Literatur ist bekannt, dass sich die lokalen Transmissionsmaxima der Interferenzringe bei monochromatischem Licht mit folgender Formel beschreiben lassen:

$$2nd \cos\phi = m\lambda \qquad\qquad (1)$$

Dabei sind n der Gruppenbrechungsindex, d die Dicke des Fensters, $\phi$ der Winkel zur optischen Achse, m die Interferenzordnung und $\lambda$ die Wellenlänge.

Wird die Wellenlänge des Lichtstrahls nun kontinuierlich variiert, wie es bei der Messung eines Spektrums notwendig ist, so wird im Allgemeinen die insgesamt transmittierte Intensität durch die zu passierenden Winkelregionen aufgrund der bei jedem einzelnen Winkel variierenden konstruktiven bzw. destruktiven Interferenz entsprechend kontinuierlich moduliert. Zur Amplitude der Modulation trägt insbesondere der pulsierend erscheinende zentrale Bereich des Ringmusters bei. Diese Modulation stellt den für technische Anwendungen in der Regel störenden Effekt dar, der mit der vorliegenden Erfindung reduziert wird.

Für senkrechten Einfall ($\phi$ = 0) erhält man aus Formel (1) die Beziehung für den Wellenlängenabstand $\Delta\lambda$ zweier Modulationsmaxima:

$$\Delta\lambda = \frac{\lambda^2}{2nd} \qquad\qquad (2)$$

was die bekannte Formel für den Abstand zweier Moden eines Fabry-Pérot Resonators darstellt.

In der Literatur wird das mit $\Delta\lambda$ periodisch strukturierte Resonanzspektrum teilweise irreführend ebenfalls mit "Fringes" bezeichnet, obwohl damit nicht eine Modulation im Winkelraum als reduzierte Darstellung des Ortsraums, sondern im Wellenlängen- bzw. Frequenzraum gemeint ist.

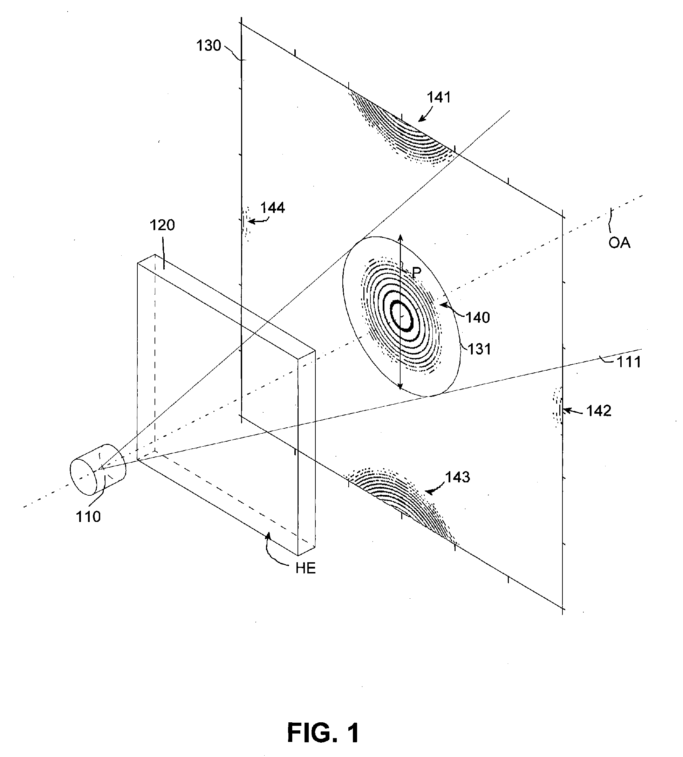

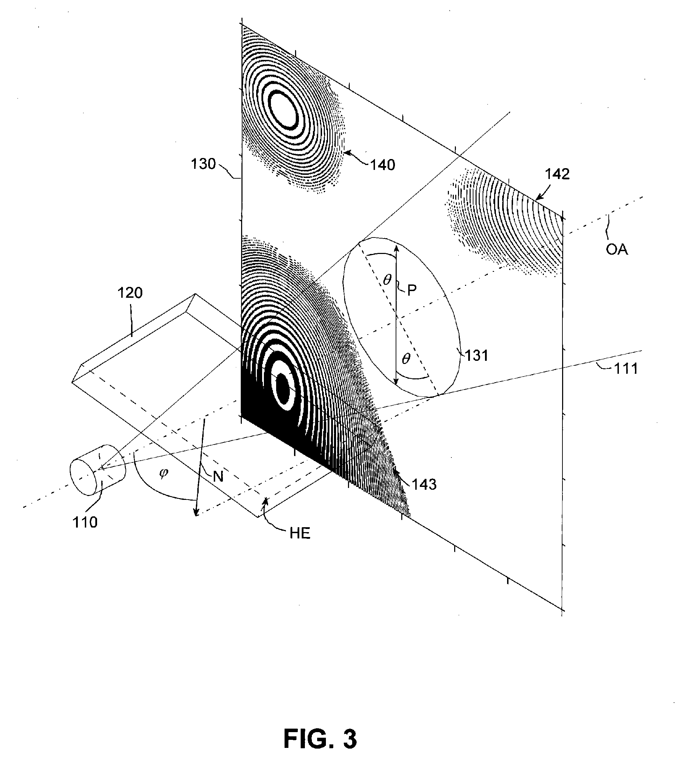

In Folgenden werden die Figuren 1 bis 3 beschrieben, in denen gleiche Elemente mit gleichen Bezugszeichen versehen sind. Die Figuren 1 bis 3 veranschaulichen, wie man ausgehend von einer Konfiguration mit senkrechtem Einfall (Figur 1) schrittweise zu einer Konfiguration gemäß einer bevorzugten Ausführungsform der Erfindung (Figur 3) gelangen kann.

Unter Bezugnahme auf Figur 1 wird nun zunächst das sich bei senkrechtem Einfall von linear polarisiertem Licht ergebende Interferenzmuster beschrieben. Eine hier als VCSEL-Laserdiode 110 ausgebildete Lichtquelle emittiert linear polarisiertes, monomodiges, näherungsweise monochromatisches Laserlicht, das als divergente Lichtstrahlung 111 mit einer Hauptabstrahlrichtung OA auf ein Austrittsfenster 120 mit einer Haupterstreckungsebene HE trifft. Zur besseren Veranschaulichung ist die Divergenz der Lichtstrahlung 111 stark übertrieben dargestellt. Die Wellenlänge der Laserdiode 110 ist einstellbar, d.h. innerhalb üblicher Grenzen variabel, bspw. durch gezielte Variation des Injektionsstroms und/oder der Laserdiodentemperatur.

Die Hauptabstrahlrichtung OA definiert zugleich die optische Achse. Die Polarisationsrichtung der Lichtstrahlung 111 ist mit einem Pfeil P gekennzeichnet.

Eine grafische Darstellungen des Interferenzmusters kann insbesondere durch numerische Berechnung der elektromagnetischen Feldvektoren auf Grundlage der Formeln von Airy und Fresnel erhalten werden, wobei letztere besonders für die quantitative Berechnung von Mehrschichtsystemen, beispielsweise Fenstern mit Antireflexionsbeschichtung, relevant sind. Das auf diese Weise berechnete Interferenzmuster ist zur Veranschaulichung in einiger Entfernung hinter dem Austrittsfenster in einem Diagramm 130 dargestellt. Der tatsächlich ausgeleuchtete Bereich ist in dem Diagramm 130 durch einen Kreis 131 gekennzeichnet.

Aufgrund der Polarisation der Lichtstrahlung 111 treten neben einem zentralen Interferenzmuster 140 zusätzliche konzentrisch erscheinende Winkelregionen als ausgeprägte Teilmuster 141, 142, 143, 144 usw. auf, die in guter Näherung auf einem Kreuz im Winkelraum angeordnet sind. Das Kreuz orientiert sich an der Polarisationsrichtung P der einfallenden Lichtstrahlung 111, so dass die Achsen parallel und senkrecht zur Polarisationsrichtung verlaufen. Bei senkrechtem Einfall schneiden sich die Achsen in der optischen Achse.

Aufgrund der effektiv auf den Bereich 131 um die optische Achse OA herum beschränkten Ausleuchtung ähnelt das transmittierte Intensitätsmuster des Lichts in Achsnähe dem des unpolarisierten Falles.

Aufgrund der Invarianz des Winkelmusters der Interferenzen gegenüber dem Abstand zwischen Lichtquelle 110 bzw. Apertur und Fenster 120 lassen sich nachfolgend ohne Einschränkung der Allgemeinheit alle Ausrichtungen des Fensters 120 gegenüber der optischen Achse OA und der Polarisationsrichtung P des einfallenden Strahls 111 durch eine Neigung und Rotation beschreiben.

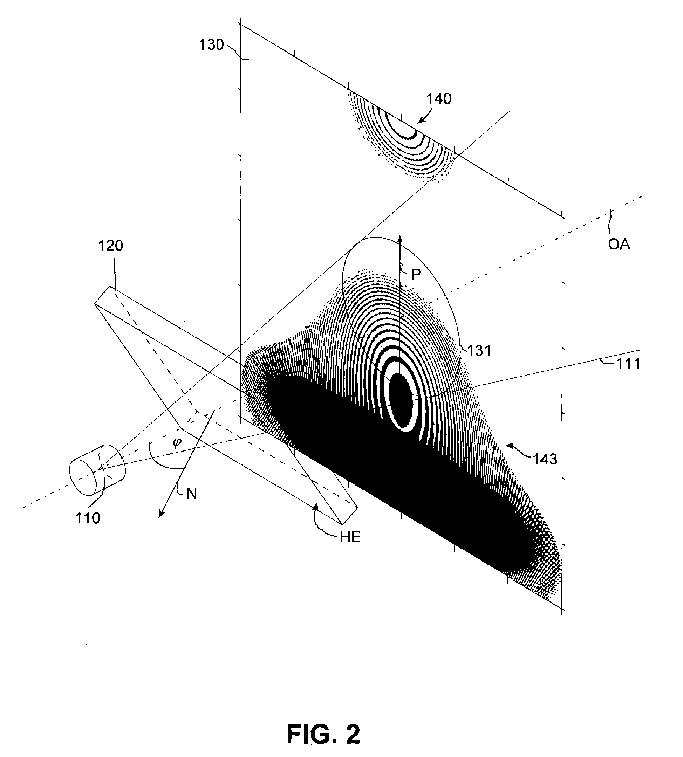

Unter Bezugnahme auf Figur 2 wird gezeigt, wie das Fenster 120 ausgehend von der Senkrechtstellung zur optischen Achse OA um einen Neigungswinkel $\varphi$ verkippt wird, so dass die Normale N auf der Haupterstreckungsebene HE mit der Hauptabstrahlrichtung OA der Lichtquelle 110 einen Neigungswinkel $\varphi$, hier 30°, einschließt. Die Verkippung bewirkt, dass das Kreuz, auf dem die ausgeprägten Teilmuster 140 usw. sitzen, gegenüber der optischen Achse OA verschoben wird. Die Ausrichtung des Kreuzes rotiert dabei nicht und bleibt an der Polarisationsrichtung P des einfallenden Strahls 111 ausgerichtet. Es ändern sich die Winkelabstände der ausgeprägten Teilmuster relativ zur optischen Achse OA. Insbesondere wird das zentrale Interferenzmuster 140 von der optischen Achse OA (in der Figur nach oben) weggeschoben. Bei der dargestellten Konfiguration liegt die Polarisationsrichtung P in der Einfallsebene, welche von N und OA aufgespannt wird. Es liegt somit eine p-Polarisation vor.

Anschließend wird das Austrittsfenster (und damit dessen Normale N) um die optische Achse OA um einen Rotationswinkel $\theta$ rotiert. Das sich dann - gemäß einer bevorzugten Ausführungsform der Erfindung - ergebende Interferenzmuster ist in Figur 3 abgebildet. Da der Lichtstrahl und damit die Polarisationsrichtung P beibehalten werden, kommt es zu einer Rotation der von N und OA aufgespannten Einfallsebene bezüglich der Polarisationsrichtung P um den Rotationswinkel $\theta$.

Die Rotation der von N und OA aufgespannten Einfallsebene bezüglich der Polarisationrichtung P um einen Rotationswinkel $\theta$ bewirkt eine weitere Verschiebung des Kreuzes und damit der Muster 140 usw. Das Kreuz bleibt weiterhin zu der Polarisationsrichtung P des einfallenden Strahls 111 ausgerichtet. Bei der dargestellten Konfiguration schließt die Polarisationsrichtung P mit der Einfallsebene, welche von N und OA aufgespannt wird, einen Rotationswinkel $\theta$ von 45° ein. Es liegt somit eine s+p-Polarisiation vor.

Insgesamt wird demnach die Möglichkeit geschaffen, die optische Achse bzw. Hauptabstrahlrichtung OA weg von den Kreuzachsen in einen Zwischenraum des Kreuzes zu legen. Da die effektiv begrenzte Winkelausdehnung des einfallenden Strahls 111 nur einen effektiv begrenzten Teil 131 des Gesamtmusters der Interferenzen ausleuchtet, kann so die Amplitude der Modulation der insgesamt transmittierten Intensität bei Variation der Wellenlänge reduziert werden. Zum einen werden hier die besonders störenden und relativ großen Zentralbereiche der Teilmuster kaum ausgeleuchtet und zum anderen liegen die hier maßgeblichen, weiter außen liegenden Ringe der Teilmuster im Winkelraum dichter zusammen, so dass sich ein technisch vorteilhafter Mittelungseffekt über die bestrahlte Winkelfläche ergibt.

Dieser Mittelungseffekt führt auch zu einem besonders vorteilhaften Effekt bezüglich der Dimensionierung der Fensterdicke. Bei senkrechtem Einfall folgt aus Formel (2), dass eine möglichst geringe Fensterdicke anzustreben ist, um ein möglichst großes $\Delta\lambda$ zu erhalten und so die ungewünschte Modulation im Wellenlängenbereich möglichst glatt zu ziehen.

Aus Formel (1) folgt jedoch, dass die Dichte der Interferenzringe in den Zwischenräumen des Kreuzes zunimmt und der damit einhergehende günstige Mittelungseffekt mit einer höheren Fensterdicke verbunden ist. Größere Fensterdicken erweisen sich daneben auch bei der Herstellung als vorteilhaft, da die Oberflächen mit weniger Aufwand in besserer Qualität poliert werden können. In Versuchen hat sich eine Fensterdicke von 1 mm bei Verwendung von Borosilikatglas bewährt.

Als besonders günstig haben sich Konfigurationen erwiesen, bei denen der Rotationswinkel 45° bzw. 135° bzw. -45° bzw. -135° beträgt. Dies wird in der Literatur als eine s+p-Polarisation des Strahls gegenüber dem Austrittsfenster beschrieben. Als günstiger Nebeneffekt ergibt sich für die Lichtquelle ein Freiheitsgrad für die Polarisation. Die Ausrichtung von Lichtquelle zu Austrittsfenster ist gegenüber Rotationen um 90° invariant. Um die absolute Modulation durch Interferenzen in Transmission weiter zu reduzieren, ist eine Entspiegelungsbeschichtung sinnvoll, die für die s+p-Polarisation optimiert ist.

Weiter hat sich ein Neigungswinkel von 30° als besonders vorteilhaft herausgestellt, da in diesem Fall einerseits hinsichtlich der wellenoptischen Eigenschaften günstige Ergebnisse zu beobachten sind und andererseits die Herstellung keine besonderen Probleme aufwirft. Bei der Produktion von Fensterkappen für Laserdioden in Rundgehäusen unterliegt die technische Umsetzung der Fenster bzw. Fensterfassungen diversen Randbedingungen aufgrund vorgegebener Gehäusestandards und Fertigungstechniken. In der Folge kann nicht jede beliebige Verkippung des Fensters in sinnvoller Weise mit üblichen Komponenten, wie z.B. zylinderförmigen Fenstergläsern, realisiert werden. Bei einer Verkippung von 30° sind jedoch keinerlei Probleme zu befürchten.

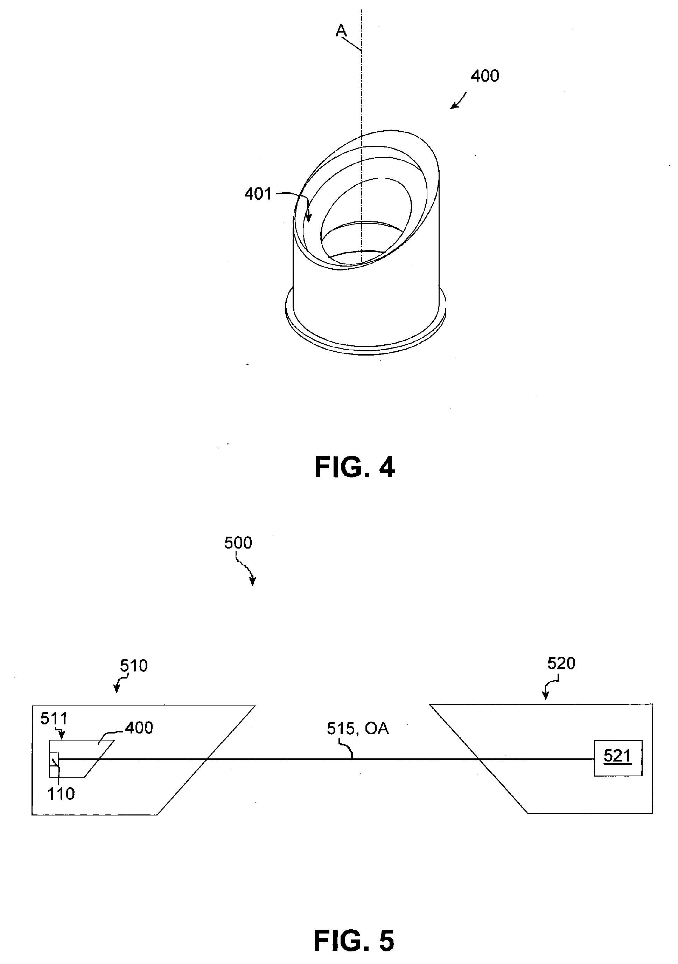

In Figur 4 ist beispielsweise eine Lösung mit Kippwinkel 30° für optische Standardgehäuse dargestellt. Ein Gehäuse bzw. eine Kappe 400 ist hier als Rundgehäuse mit einer Mittelachse A ausgebildet, das eine Aufnahme 401 für ein Austrittsfenster aufweist. Die Aufnahme 401 ist so an dem Gehäuse 400 vorgesehen, dass sich ein Neigungswinkel φ von hier 30° zwischen der Normalen auf der Haupterstreckungsebene des Fensters und der Hauptabstrahlrichtung (hier Mittelachse A des Gehäuses) ausbildet. Beim Ausrichten der Lichtquelle, bspw. einer VCSEL-Laserdiode, wird diese vorzugsweise so in das Gehäuse eingesetzt, dass sich eine s+p-Polarisation, wie oben beschrieben, ergibt. Zur Unterdrückung von störenden Reflexionen kann das Gehäuse insbesondere innen entsprechend beschichtet oder gefärbt sein, insbesondere schwarz gefärbt.

In Figur 5 ist eine bevorzugte Ausführungsform eines erfindungsgemäßen Gasdetektors in einer schematischen Querschnittsansicht dargestellt und insgesamt mit 500 bezeichnet. Der Gasdetektor 500 ist als OPGD (Open Path Gas Detector) ausgebildet und umfasst einen Transmitter bzw. Sender 510 und einen Receiver bzw. Empfänger 520.

Der Sender 510 umfasst eine bevorzugte Ausführungsform einer erfindungsgemäßen Leuchteinheit 511, welche eine hier als VCSEL Laserdiode 110 ausgebildete Lichtquelle sowie ein Gehäuse 400 gemäß Figur 4 umfasst. Der Sender 510 umfasst weitere, nicht dargestellte Elemente, insbesondere zur Ansteuerung und Versorgung der Leuchteinheit 511.

Die Leuchteinheit 511 gibt eine linear polarisierte Lichtstrahlung 515 in eine Hauptabstrahlrichtung OA ab, die auf den Empfänger 520 gerichtet ist.

Der Empfänger 520 umfasst einen Detektor 521 zum Detektieren der Intensität der Lichtstrahlung 515 sowie weitere, nicht dargestellte Elemente zur Versorgung und Ansteuerung des Detektors 521.

Für weitere Details betreffend die Gasdetektion sei an dieser Stelle beispielhaft auf die WO 2005/088275 A1 verwiesen.

## Patentansprüche

1. Leuchteinheit für einen Gasdetektor (500), welche eine Lichtquelle (110) für linear polarisierte Lichtstrahlung (111; 515) und ein Gehäuse (400) mit einem Austrittsfenster (120) aufweist,
   wobei die Wellenlänge der von der Lichtquelle (110) abgestrahlten Lichtstrahlung (111; 515) einstellbar ist,
   wobei die Lichtquelle (110) so in dem Gehäuse (400) angeordnet ist, dass die Hauptabstrahlrichtung (OA) der Lichtquelle (110) mit einer Normalen (N) auf der Haupterstreckungsebene (HE) des Austrittsfensters (120) einen Neigungswinkel (φ) zwischen 10° und 50° einschließt, **dadurch gekennzeichnet, dass**
   die Polarisationsrichtung (P) der Lichtstrahlung mit der Einfallsebene auf das Austrittsfenster (120) einen Rotationswinkel (θ) zwischen 22,5° und 67,5° einschließt.

2. Leuchteinheit nach Anspruch 1, wobei der Rotationswinkel (θ) zwischen 30° und 60° liegt, vorzugsweise zwischen 35° und 55°, insbesondere bei 45°.

3. Leuchteinheit nach Anspruch 1 oder 2, wobei der Neigungswinkel (θ) zwischen 20° und 40° liegt, vorzugsweise zwischen 25° und 35°, insbesondere bei 30°.

4. Leuchteinheit nach einem der vorstehenden Ansprüche, wobei das Austrittsfenster (120) eine Antireflexbeschichtung für s+p-polarisiertes Licht aufweist.

5. Leuchteinheit nach einem der vorstehenden Ansprüche, wobei das Austrittsfenster (120) eine Dicke von wenigstens 0,2 mm, vorzugsweise von wenigstens 1 mm, und von höchstens 1,5 mm aufweist.

6. Leuchteinheit nach einem der vorstehenden Ansprüche, wobei die Lichtquelle (110) als Laserdiode, insbesondere als VCSEL, ausgebildet ist.

7. Leuchteinheit nach einem der vorstehenden Ansprüche, wobei die Lichtquelle (110) monomodig ist.

8. Leuchteinheit nach Anspruch 7, wobei die Lichtquelle (110) eine monomodige Laserdiode oder eine, insbesondere monomodige, Glasfaser, aus der monomodige Lichtstrahlung (111; 515) austritt, aufweist.

9. Gasdetektor (500) umfassend eine Leuchteinheit (511) nach einem der vorstehenden Ansprüche.

10. Verwendung einer Leuchteinheit (511) nach einem der Ansprüche 1 bis 8 in einem optischen Gasdetektor (500) zur Aufnahme eines Absorptionsspektrums.

11. Verfahren zur Aufnahme eines Absorptionsspektrums in einem optischen Gasdetektor (500) nach Anspruch 9, wobei ein zu untersuchendes Volumen mit von der Lichtquelle (110) abgestrahlter im Wesentlichen monochromatischer Lichtstrahlung (111; 515) wenigstens einer ersten und einer davon unterschiedlichen zweiten Wellenlänge durchstrahlt wird und jeweils die Absorption der Lichtstrahlung (111; 515) der ersten und der zweiten Wellenlänge in dem zu untersuchenden Volumen gemessen wird.

**Claims**

1. Illumination unit for a gas detector (500), which comprises a light source (110) for linearly polarised light radiation (111; 515) and a housing (400) having an exit window (120),
the wavelength of the light radiation (111; 515) radiated from the light source (110) being adjustable,
the light source (110) being arranged in the housing (400) such that the main emission direction (OA) of the light source encloses an angle of inclination ($\varphi$) of between 10 ° and 50 ° with a normal (N) to the main extension plane (HE) of the exit window (120),
**characterised in that**
the direction of polarisation (P) of the light radiation encloses a rotation angle ($\theta$) of between 22.5° and 67.5° with the plane of incidence on the exit window (120).

2. Illumination unit according to claim 1, wherein the rotation angle ($\theta$) is between 30° and 60°, preferably between 35° and 55°, particularly 45°.

3. Illumination unit according to claim 1 or 2, wherein the angle of inclination ($\varphi$) is between 20° and 40°, preferably between 25° and 35°, particularly 30°.

4. Illumination unit according to one of the preceding claims, wherein the exit window (120) has an antireflection coating for s+p-polarised light.

5. Illumination unit according to one of the preceding claims, wherein the exit window (120) has a thickness of at least 0.2 mm, preferably at least 1 mm, and at most 1.5 mm.

6. Illumination unit according to one of the preceding claims, wherein the light source (110) is embodied as a laser diode, particularly as a VCSEL.

7. Illumination unit according to one of the preceding claims, wherein the light source (110) is monomodal.

8. Illumination unit according to claim 7, wherein the light source (110) comprises a monomodal laser diode or an in particular monomodal glass fibre from which monomodal light radiation (111; 515) is emitted.

9. Gas detector (500) comprising an illumination unit (511) according to one of the preceding claims.

10. Use of an illumination unit (511) according to one of claims 1 to 8 in an optical gas detector (500) for recording an absorption spectrum.

11. Method of recording an absorption spectrum in an optical gas detector (500) according to claim 9, wherein a volume to be investigated is irradiated with substantially monochromatic light radiation (111; 515) which is emitted from the light source (110), of at least a first wavelength and of a second wavelength different from the first, and in each case the absorption of the light radiation (111; 515) of the first and second wavelength in the volume that is to be investigated is measured.

**Revendications**

1. Unité d'éclairage pour un détecteur de gaz (500), laquelle comporte une source de lumière (110) pour un rayonnement lumineux polarisé linéairement (111 ; 515) et un boîtier (400) ayant une fenêtre de sortie (120),

dans laquelle la longueur d'onde du rayonnement lumineux (111 ; 515) émis par la source de lumière (110) est réglable,

dans laquelle la source de lumière (110) est agencée dans le boîtier (400) de telle sorte que la direction d'émission principale (OA) de la source de lumière (110) inclut un angle d'inclinaison ($\varphi$) compris entre 10 ° et 50 ° avec une perpendiculaire (N) au plan d'extension principal (HE) de la fenêtre de sortie (120),

caractérisée ce que

la direction de polarisation (P) du rayonnement lumineux inclut un angle de rotation ($\theta$) compris entre 22,5° et 67,5° avec le plan d'incidence de la fenêtre de sortie (120).

2. Unité d'éclairage selon la revendication 1, dans laquelle l'angle de rotation ($\theta$) est compris entre 30° et 60°, de préférence entre 35° et 55°, en particulier égal à 45°.

3. Unité d'éclairage selon la revendication 1 ou 2, dans laquelle l'angle d'inclinaison ($\varphi$) est compris entre 20° et 40°, de préférence entre 25° et 35°, en particulier égal à 30°.

4. Unité d'éclairage selon l'une des revendications précédentes, dans laquelle la fenêtre de sortie (120) a un revêtement anti-réflexion pour une lumière polarisée s+p.

5. Unité d'éclairage selon l'une des revendications précédentes, dans laquelle la fenêtre de sortie (120) a une épaisseur d'au moins 0,2 mm, de préférence d'au moins 1 mm et d'au plus 1,5 mm.

6. Unité d'éclairage selon l'une des revendications précédentes, dans laquelle la source de lumière (110) est configurée sous la forme d'une diode laser, en particulier d'une VCSEL.

7. Unité d'éclairage selon l'une des revendications précédentes, dans laquelle la source de lumière (110) est monomode.

8. Unité d'éclairage selon la revendication 7, dans laquelle la source de lumière (110) comporte une diode laser monomode ou une fibre de verre, en particulier monomode, à partir de laquelle un rayonnement lumineux monomode (111 ; 515) est émis.

9. Détecteur de gaz (500) comportant une unité d'éclairage (511) selon l'une des revendications précédentes.

10. Utilisation d'une unité d'éclairage (511) selon l'une des revendications 1 à 8 dans un détecteur de gaz optique (500) pour enregistrer un spectre d'absorption.

11. Procédé d'enregistrement d'un spectre d'absorption dans un détecteur de gaz optique (500) selon la revendication 9, dans lequel un volume à examiner est traversée par un rayonnement lumineux sensiblement monochromatique (111 ; 515) qui est émis par la source de lumière (110), d'au moins une première longueur d'onde et d'une seconde longueur d'onde différente de la première, et dans chaque cas, l'absorption du rayonnement lumineux (111 ; 515) des première et seconde longueurs d'onde dans le volume à examiner est mesurée.

**FIG. 1**

**FIG. 2**

**FIG. 3**

A

400

401

**FIG. 4**

500

510

520

511
400
515, OA
521
110

**FIG. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1783481 A1
- US 5637872 A
- US 7113658 B2
- WO 2005088275 A1